# EUROPEAN PATENT APPLICATION

(11) **EP 4 723 859 A1**
(43) Date of publication of application: **08.04.2026**
(21) Application number: 25205121.4
(22) Date of filing: 26.09.2025
(51) Int. Cl.: H10N 60/01, H10N 60/12

(54) **JOSEPHSON JUNCTION ELEMENT AND METHOD FOR MANUFACTURING JOSEPHSON JUNCTION ELEMENT**

(30) Priority: 27.09.2024 JP 2024169401
(71) Applicant: FUJITSU LIMITED, Kawasaki-shi, Kanagawa 211-8588 (JP)
(72) Inventor: HAYASHI, Kenjiro, Kawasaki-shi, 211-8588 (JP)
(74) Representative: Haseltine Lake Kempner LLP

(57) **Abstract**

A first wiring made of a superconductor and a first electrode made of a superconductor connected to the first wiring are formed on a substrate. A resist mask that covers at least the first wiring is formed. A surface of the first electrode using the resist mask is etched. An insulator film on the surface of the first electrode using the resist mask is formed. A second electrode made of a superconductor on the surface of the insulator film using the resist mask is formed.

## Description

### FIELD

The disclosed technology relates to a Josephson junction element and a method for manufacturing the same.

### BACKGROUND

The following technologies are known as technologies relating to a method for manufacturing a Josephson junction element. For example, Patent Literature 1 describes a manufacturing method including forming a lower superconducting layer and an insulating layer in this order on a substrate, forming an edge structure having an inclination on a surface of the insulating layer, and forming a superconducting thin film on an inclined surface of the insulating layer via a barrier layer.

Patent Literature 2 describes a manufacturing method including attaching a first superconducting layer to a surface of a base, attaching a dielectric layer to the first superconducting layer, forming an inclined edge inclined with respect to the surface of the base on the first superconducting layer and the dielectric layer, attaching a second superconducting layer on the inclined edge, attaching a barrier layer on the second superconducting layer, and attaching a third superconducting layer on the barrier layer.

Patent Literature 3 describes a manufacturing method including a step of forming a first YBCO superconducting thin film and an insulating layer thin film on an oxide single crystal substrate, a step of forming a first photoresist pattern on the insulating layer thin film and obliquely removing the insulating layer thin film and the first superconducting thin film exposed by etching, a step of forming a non-superconducting cubic YBCO barrier thin film, a second YBCO superconducting thin film, and a protective layer thin film on the entire surface of the substrate, and a step of forming a second photoresist pattern exposing the opposite side of the obliquely etched portion on the protective layer thin film and etching the protective layer thin film and the obliquely continuously exposed second YBCO superconducting thin film and non-superconducting cubic YBCO barrier thin film.

Patent Literature 4 describes that after a photoresist material is applied to a target region, photolithography and ion milling are used to form an edge of a required angle.

### Related Patent Documents

Patent Literature 1: Japanese Patent Application Laid-Open (JP-A) No. H10-173246
Patent Literature 2: Japanese Patent Application Laid-Open (JP-A) No. H11-31853
Patent Literature 3: US Patent No. 6004907
Patent Literature 4: US Patent No. 6476413

A quantum bit in a superconducting circuit system includes a Josephson junction element. The Josephson junction element has a structure in which an insulator film functioning as a barrier layer is sandwiched between two superconductor films. As a method for manufacturing the Josephson junction element, a so-called oblique deposition method is known. The oblique deposition method is a method of performing deposition over a plurality of times using a single resist mask while changing the direction of the substrate with respect to the deposition source. The insulator film functioning as the barrier layer is formed by oxidizing the surface of the superconductor film formed by the first vapor deposition in the vapor deposition apparatus.

According to the oblique deposition method, the superconductor film/insulator film/superconductor film can be formed in a vacuum-integrated process of continuously forming in a common vacuum chamber. Furthermore, patterning of the three-layer structure including the superconductor film/insulator film/superconductor film can be performed using a single resist mask. Therefore, according to the oblique deposition method, it is possible to avoid exposure of the three-layer structure to the atmosphere and incorporation of impurities resulting from patterning of the resist at the interface between the superconductor film and the insulator film.

On the other hand, according to the oblique deposition method, since the inclination angle of the path from the vapor deposition source to each position on the substrate changes according to the position on the substrate, the area (junction area) of the portion where the three layers of the superconductor film/insulator film/superconductor film overlap changes according to the position on the substrate. As a result, there is a possibility that the characteristics of the quantum bit configured to include the three-layer structure are non-uniform in the substrate surface.

### SUMMARY

The disclosed technology has been made in view of the above points, and it is desirable to suppress variations in a junction area in a substrate surface while avoiding incorporation of impurities into a junction between a superconductor film and an insulator film in a Josephson junction element.

A method for manufacturing a Josephson junction element according to the disclosed technology includes: forming a first wiring made of a superconductor and a first electrode made of a superconductor connected to the first wiring on a substrate; forming a resist mask that covers at least the first wiring; etching a surface of the first electrode using the resist mask; forming an insulator film on the surface of the first electrode using the resist mask; and forming a second electrode made of a superconductor on the surface of the insulator film using the resist mask.

### BRIEF DESCRIPTION OF THE DRAWINGS

The invention is described, by way of example only, with reference to the following drawings, in which:
Fig. 1 is a plan view illustrating an example of a configuration of a Josephson junction element according to an embodiment of the disclosed technology;
Fig. 2 is a cross-sectional view taken along a line 2-2 in Fig. 1;
Fig. 3A is a plan view illustrating an example of a method for manufacturing the Josephson junction element according to the embodiment of the disclosed technology;
Fig. 3B is a plan view illustrating an example of the method for manufacturing the Josephson junction element according to the embodiment of the disclosed technology;
Fig. 3C is a plan view illustrating an example of the method for manufacturing the Josephson junction element according to the embodiment of the disclosed technology;
Fig. 3D is a plan view illustrating an example of the method for manufacturing the Josephson junction element according to the embodiment of the disclosed technology;
Fig. 3E is a plan view illustrating an example of the method for manufacturing the Josephson junction element according to the embodiment of the disclosed technology;
Fig. 3F is a plan view illustrating an example of the method for manufacturing the Josephson junction element according to the embodiment of the disclosed technology;
Fig. 3G is a plan view illustrating an example of the method for manufacturing the Josephson junction element according to the embodiment of the disclosed technology;
Fig. 4A is a cross-sectional view taken along a line 4A-4A in Fig. 3A;
Fig. 4B is a cross-sectional view taken along a line 4B-4B in Fig. 3B;
Fig. 4C is a cross-sectional view taken along a line 4C-4C in Fig. 3C;
Fig. 4D is a cross-sectional view taken along a line 4D-4D in Fig. 3D;
Fig. 4E is a cross-sectional view taken along a line 4E-4E in Fig. 3E;
Fig. 4F is a cross-sectional view taken along a line 4F-4F in Fig. 3F;
Fig. 4G is a cross-sectional view taken along a line 4G-4G in Fig. 3G;
Fig. 5A is a cross-sectional view showing an example of a method for manufacturing a Josephson junction element using an oblique deposition method;
Fig. 5B is a cross-sectional view illustrating an example of the method for manufacturing the Josephson junction element using the oblique deposition method;
Fig. 6A is a perspective view illustrating an example of a method for manufacturing a Josephson junction element using an oblique deposition method;
Fig. 6B is a cross-sectional view illustrating an example of the method for manufacturing the Josephson junction element using the oblique deposition method;
Fig. 6C is a cross-sectional view illustrating an example of the method for manufacturing the Josephson junction element using the oblique deposition method;
Fig. 7 is a cross-sectional view illustrating an example of a configuration of a Josephson junction element according to another embodiment of the disclosed technology;
Fig. 8A is a cross-sectional view illustrating an example of a method for manufacturing a Josephson junction element according to another embodiment of the disclosed technology;
Fig. 8B is a cross-sectional view illustrating an example of a method for manufacturing the Josephson junction element according to another embodiment of the disclosed technology;
Fig. 8C is a cross-sectional view illustrating an example of a method for manufacturing a Josephson junction element according to another embodiment of the disclosed technology;
Fig. 8D is a cross-sectional view illustrating an example of a method for manufacturing a Josephson junction element according to another embodiment of the disclosed technology; and
Fig. 9 is a cross-sectional view illustrating an example of a method for manufacturing a Josephson junction element according to another embodiment of the disclosed technology.

### DESCRIPTION OF EMBODIMENTS

Hereinafter, an example of an embodiment of the disclosed technology will be described with reference to the drawings. In the drawings, the same or equivalent components and portions are denoted by the same reference numerals, and redundant description is omitted.

### First Embodiment

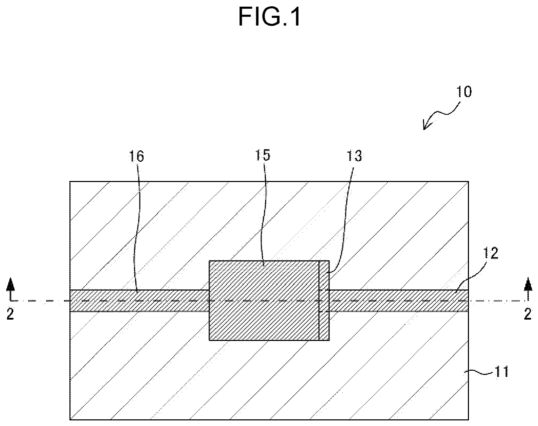

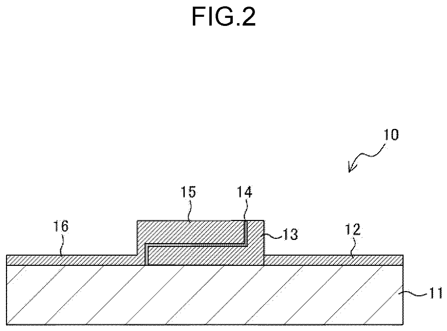

Fig. 1 is a plan view illustrating an example of a configuration of a Josephson junction element 10 according to an embodiment of the disclosed technology. Fig. 2 is a cross-sectional view taken along a line 2-2 in Fig. 1. The Josephson junction element 10 includes a substrate 11, a first wiring 12, a first electrode 13, an insulator film 14, a second electrode 15, and a second wiring 16. Each of the first wiring 12, the first electrode 13, the second electrode 15, and the second wiring 16 is formed using a material made of a superconductor. The first wiring 12 is provided on the substrate 11. The first electrode 13 is provided on the substrate 11 and connected to the first wiring 12. The insulator film 14 is provided on the surface of the first electrode 13. The second electrode 15 is provided on the surface of the insulator film 14. That is, the insulator film 14 is sandwiched between the first electrode 13 and the second electrode 15 each made of a superconductor. The second wiring 16 is provided on the substrate 11 and connected to the second electrode 15.

As the first electrode 13 and the second electrode 15 made of a superconductor are weakly coupled via the insulator film 14, a phenomenon in which a superconducting electron pair (Cooper pair) tunnels through the insulator film 14 is observed. This phenomenon is called the Josephson effect, and a weak bond between the superconductors is called a Josephson junction.

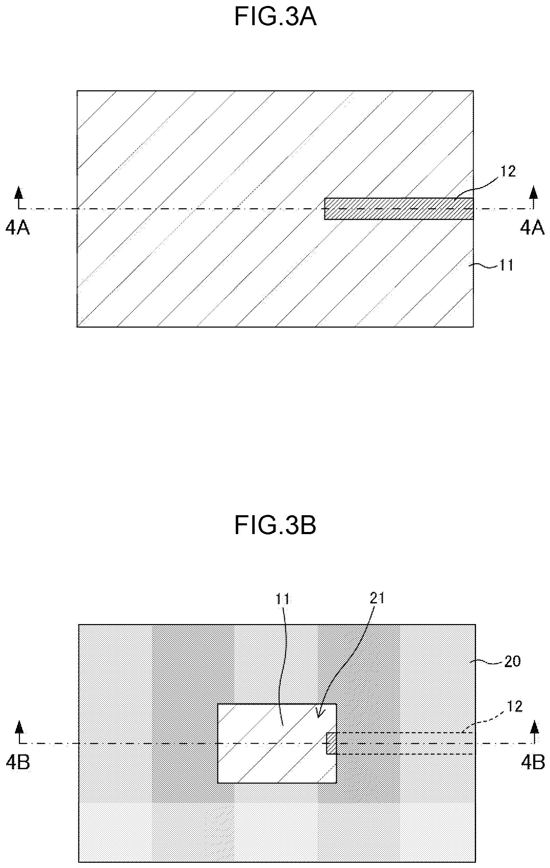

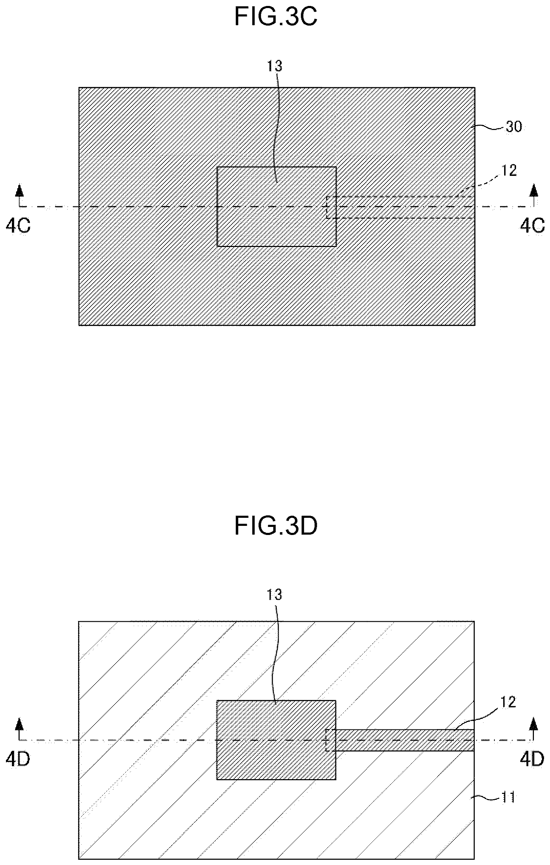

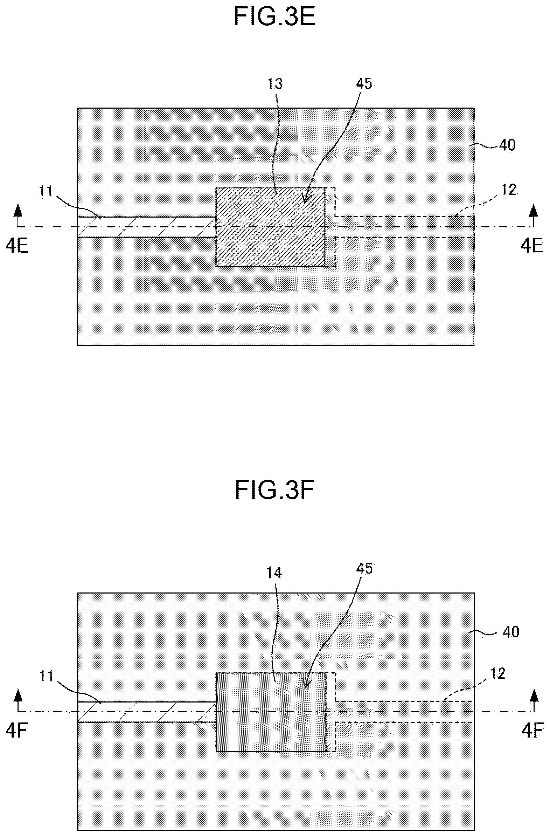

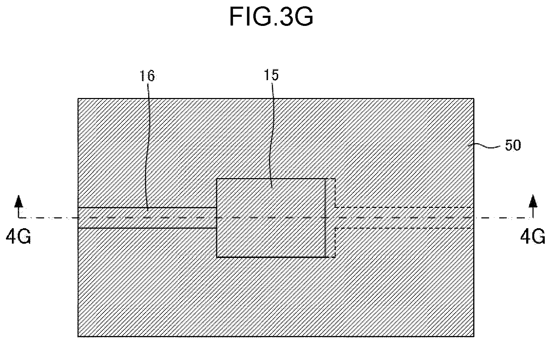

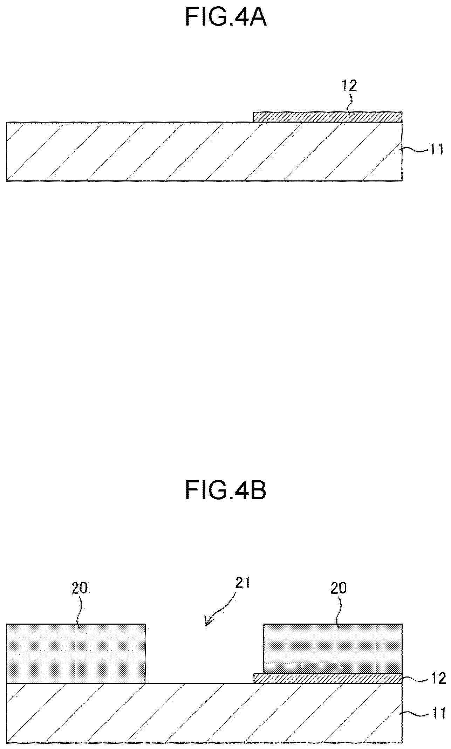

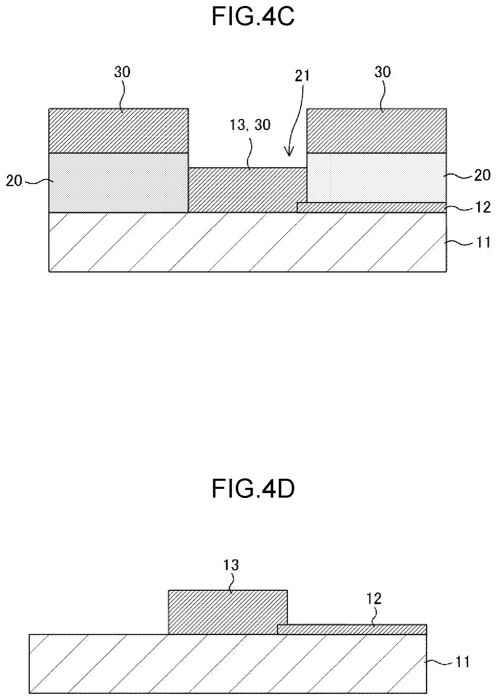

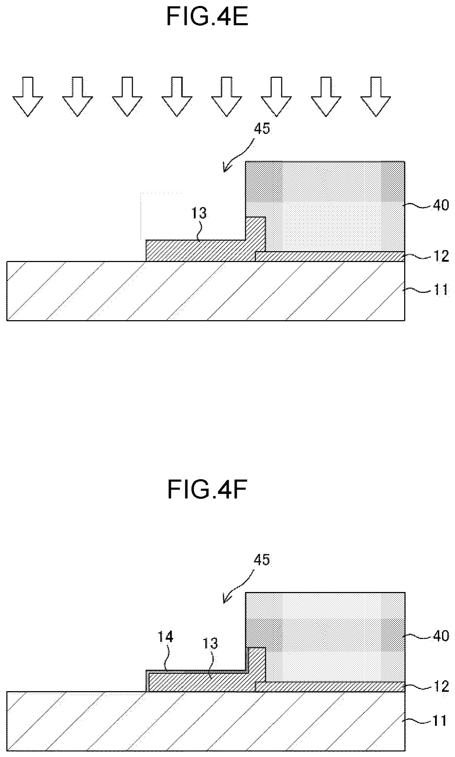

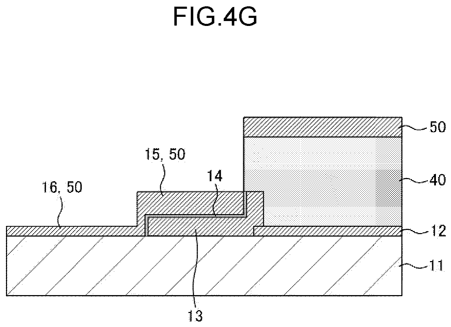

Hereinafter, a method for manufacturing the Josephson junction element 10 will be described. Figs. 3A, 3B, 3C, 3D, 3E, 3F, and 3G are plan views illustrating an example of a method for manufacturing the Josephson junction element 10. Fig. 4A is a cross-sectional view taken along a line 4A-4A in Fig. 3A. Fig. 4B is a cross-sectional view taken along a line 4B-4B in Fig. 3B. Fig. 4C is a cross-sectional view taken along a line 4C-4C in Fig. 3C. Fig. 4D is a cross-sectional view taken along a line 4D-4D in Fig. 3D. Fig. 4E is a cross-sectional view taken along a line 4E-4E in Fig. 3E. Fig. 4F is a cross-sectional view taken along a line 4F-4F in Fig. 3F. Fig. 4G is a cross-sectional view taken along a line 4G-4G in Fig. 3G.

First, the first wiring 12 made of a superconductor is formed on the substrate 11 (Figs. 3A and 4A). The substrate 11 is preferably an insulator, and may be, for example, a non-doped silicon substrate, a sapphire substrate, or a magnesium oxide substrate.

The first wiring 12 may be made of a metal that exhibits superconductivity at a low temperature. As a material of the first wiring 12, for example, Nb, Al, TiN, NbN, or Nb₃Al can be used. For example, a resist patterned by lithography is formed on the substrate 11, a superconductor film is formed on the substrate 11 on which the resist is formed by sputtering or vapor deposition, and an excessive superconductor film is removed together with the resist, whereby the first wiring 12 is formed. Alternatively, the first wiring 12 may be formed by forming a superconductor film on the entire surface of the substrate 11, covering the surface of the superconductor film with a resist mask having a pattern corresponding to the pattern of the first wiring 12, and removing the exposed portion of the superconductor film by dry etching. The type of gas used in the dry etching is appropriately selected depending on the materials of the resist mask and the superconductor film.

Next, a resist mask 20 for patterning the first electrode 13 made of a superconductor connected to the first wiring 12 by lift-off is formed (Figs. 3B and 4B). The resist mask 20 has an opening 21 corresponding to the pattern of the first electrode 13, and the surface of the substrate 11 and the end portion of the first wiring 12 are exposed in the opening 21.

Next, the superconductor film 30 constituting the first electrode 13 is formed by a vapor deposition method or a sputtering method. The superconductor film 30 is formed on the surface of the substrate 11 exposed at the opening 21 of the resist mask 20, and is formed on the surface of the resist mask 20 (Figs. 3C and 4C). The material of the first electrode 13 may be the same as that of the first wiring 12. The thickness of the superconductor film 30 is, for example, several tens to several hundreds of nm. The orientation of the substrate 11 during vapor deposition or sputtering is set so as to face the vapor deposition source or the sputtering source. That is, the superconductor film 30 constituting the first electrode 13 is formed by a method different from the oblique deposition.

Next, the excess superconductor film 30 deposited on the resist mask 20 is removed together with the resist mask 20. As a result, the first electrode 13 is patterned (Figs. 3D and 4D).

Next, a resist mask 40 for patterning the second electrode 15 and the second wiring 16 by lift-off is formed (Figs. 3E and 4E). The resist mask 40 has an opening 45 corresponding to the patterns of the second electrode 15 and the second wiring 16. The surface of the first electrode 13 is exposed at a portion of the opening 45 corresponding to the second electrode 15, and the surface of the substrate 11 is exposed at a portion of the opening 45 corresponding to the second wiring 16. A part of the first electrode 13 and the entire first wiring 12 are covered with the resist mask 40. The surface of the substrate 11 is covered with the resist mask 40 except for the portion corresponding to the second wiring 16.

Next, the surface of the first electrode 13 exposed in the opening 45 of the resist mask 40 is etched by dry etching or wet etching (Figs. 3E and 4E). As a result, impurities such as residues of the resist mask 40 attached to the surface of the first electrode 13 are removed, and the surface of the first electrode 13 is cleaned. Note that the part of the surface of the first electrode 13 may be removed by this etching to thin the first electrode 13.

Next, the insulator film 14 is formed on the surface of the first electrode 13 exposed in the opening 45 of the resist mask 40 (Figs. 3F and 4F). The insulator film 14 may be formed by modifying the surface of the first electrode 13. For example, an oxide film may be formed as the insulator film 14 by exposing the surface of the first electrode 13 to oxygen gas. The oxygen partial pressure at this time is about 1 Pa to 10 kPa, and the exposure time is 1 minute to 10 hours. The substrate temperature is preferably set in a range in which the resist mask 40 is not cured, and is, for example, about 25°C to 200°C. In addition, an oxide film, a nitride film, or an oxynitride film may be formed as the insulator film 14 by exposing the surface of the first electrode 13 to oxygen plasma or nitrogen plasma. A material of the insulator film 14 is preferably appropriately selected according to a material of the first electrode 13, and a gas type to be used for obtaining a desired insulator film 14 is appropriately selected.

In addition, after a superconductor film different from the first electrode 13 is formed on the surface of the first electrode 13, the surface of the superconductor film may be modified to form an insulator film. According to this method, an insulator film containing a material not included in the first electrode 13 can be formed. For example, when Nb is used as the material of the first electrode 13, an Al film is formed on the surface of the first electrode 13, and the surface of the Al film is oxidized to obtain a laminated structure of Nb/Al/AlO_{X}

Furthermore, the insulator film 14 may be formed by sputtering. In this case, for example, aluminum oxide (AlO_{X}),aluminum nitride (AlN), or niobium oxide (NbO_{X}) can be used as the material of the insulator film 14.

Next, a superconductor film 50 constituting the second electrode 15 and the second wiring 16 is formed by a vapor deposition method or a sputtering method. The superconductor film 50 is formed on the surfaces of the substrate 11 and the insulator film 14 exposed at the opening 45 of the resist mask 40, and is formed on the surface of the resist mask 40 (Figs. 3G and 4G). The materials of the second electrode 15 and the second wiring 16 may be the same as those of the first electrode 13 and the first wiring 12. The thickness of the superconductor film 50 is, for example, several tens to several hundreds of nm. The orientation of the substrate 11 during vapor deposition or sputtering is set so as to face the vapor deposition source or the sputtering source. That is, the film of the superconductor film 50 constituting the second electrode 15 and the second wiring 16 is formed by a method different from the conventional oblique deposition.

Next, the excess superconductor film 50 deposited on the resist mask 40 is removed together with the resist mask 40. As a result, the second electrode 15 and the second wiring 16 are patterned, and the Josephson junction element is completed (Figs. 1 and 2).

The step of etching the surface of the first electrode 13 (Figs. 3E and 4E), the step of forming the insulator film 14 on the surface of the first electrode 13 (Figs. 3F and 4F), and the step of forming the second electrode 15 on the surface of the insulator film 14 and forming the second wiring 16 on the substrate 11 (Figs. 3G and 4G) are continuously performed in a common vacuum chamber. From the start to the end of the above three steps, the inside of the vacuum chamber is not exposed to the atmosphere. The resist mask 40 masks the surfaces of the substrate 11 and the first wiring 12 over the above three steps.

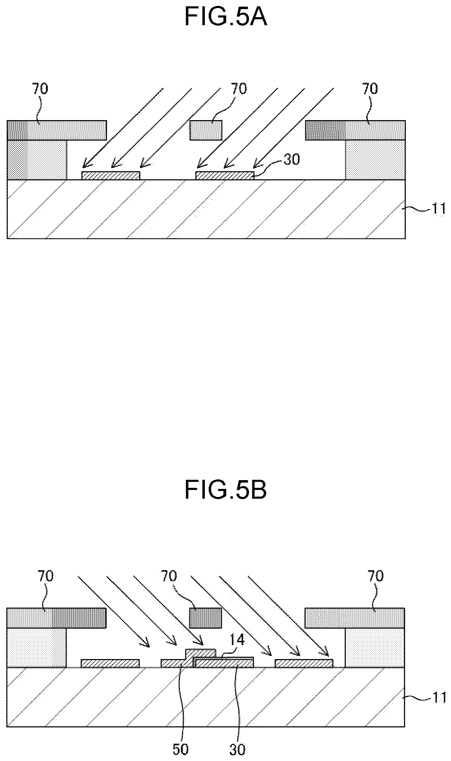

Figs. 5A and 5B are cross-sectional views illustrating an example of a method for manufacturing a Josephson junction element using an oblique deposition method according to a comparative example. In the oblique deposition method, a resist mask 70 having an overhang structure is used.

First, the orientation of the substrate 11 is set such that the flight path of the deposition target particles from the deposition source serving as the material of the superconductor film to the substrate 11 is inclined with respect to the substrate surface, and the first deposition is performed. The deposition target particles fly from an oblique direction with respect to the substrate surface and are deposited on the substrate 11. As a result, the superconductor film 30 constituting the first electrode is formed on the substrate 11. The superconductor film 30 is formed to have a pattern corresponding to the resist mask 70 (Fig. 5A). Next, the insulator film 14 is formed on the surface of the superconductor film 30 by oxidizing the surface of the superconductor film 30.

Next, the orientation of the substrate 11 is set such that the flight path of the deposition target particles is inclined with respect to the substrate surface in a direction different from that in the first deposition, and the second deposition is performed. The deposition target particles fly from an oblique direction different from the first deposition with respect to the substrate surface and are deposited on the substrate 11. As a result, the superconductor film 50 constituting the second electrode is formed on the substrate 11 and the insulator film 14. The superconductor film 50 is formed to have a pattern corresponding to the resist mask 70 (Fig. 5B). The resist mask 70 common to the first deposition and the second deposition is used. Since the region to be the shadow of the resist mask 70 on the substrate 11 is changed by changing the orientation of the substrate 11 in the first deposition and the second deposition, it is possible to form the superconductor films 30 and 50 at different positions on the substrate 11.

According to the oblique deposition method, the superconductor film 30/insulator film 14/superconductor film 50 can be formed by a vacuum-integrated process of continuously forming in a common vacuum chamber. Furthermore, the three-layer structure including the superconductor film 30/insulator film 14/superconductor film 50 can be patterned using a single resist mask 70. Therefore, according to the oblique deposition method, it is possible to avoid exposure of the three-layer structure to the atmosphere and incorporation of impurities resulting from patterning of the resist at the interface between the superconductor film and the insulator film.

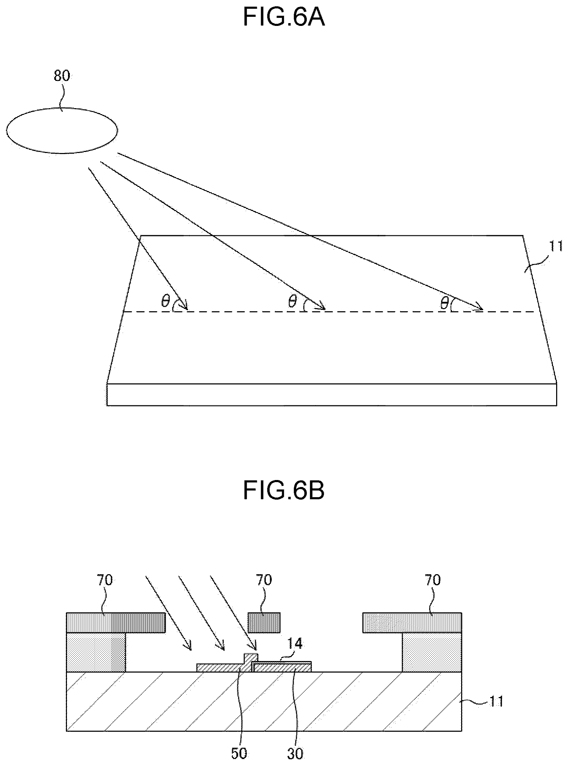

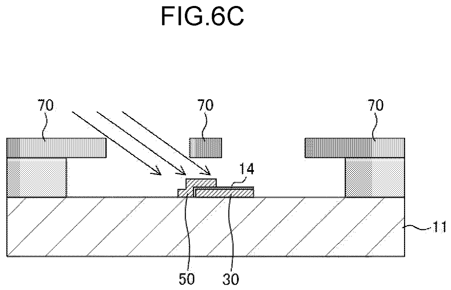

On the other hand, according to the oblique deposition method, as illustrated in Fig. 6A, an inclination angle θ of the flight path of the vapor deposition target particles from the vapor deposition source 80 to each position on the substrate 11 changes according to the position on the substrate 11, so that the size of the area (junction area) of the portion where the three layers of the superconductor film 30/insulator film 14/superconductor film 50 overlap changes according to the position on the substrate 11. Fig. 6B is a cross-sectional view of the three-layer structure formed at a position where the inclination angle θ becomes relatively large on the substrate 11. At the position where the inclination angle θ becomes relatively large, the area (junction area) of the portion where the three layers of the superconductor film 30/insulator film 14/superconductor film 50 overlap becomes relatively small. Fig. 6C is a cross-sectional view of the three-layer structure formed at a position where the inclination angle θ becomes relatively small on the substrate 11. At the position where the inclination angle θ becomes relatively small, the area (junction area) of the portion where the three layers of the superconductor film 30/insulator film 14/superconductor film 50 overlap becomes relatively large. As described above, according to the oblique deposition method, since the area (junction area) of the portion where the three layers of the superconductor film 30/insulator film 14/superconductor film 50 overlap changes according to the position on the substrate 11, there is a possibility that the characteristics of the quantum bit configured to include the three-layer structure become non-uniform in the substrate surface.

On the other hand, a method for manufacturing a Josephson junction element according to an embodiment of the disclosed technology includes a step of forming a first wiring 12 made of a superconductor and a first electrode 13 made of a superconductor connected to the first wiring 12 on a substrate 11, a step of forming a resist mask 40 covering at least the first wiring 12, a step of etching the surface of the first electrode 13 using the resist mask 40, a step of forming an insulator film 14 on the surface of the first electrode 13 using the resist mask 40, and a step of forming second electrode 15 made of a superconductor on the surface of the insulator film 14 using the resist mask 40.

According to the manufacturing method according to the embodiment of the disclosed technology, in the vapor deposition or sputtering for forming the first electrode 13 and the second electrode 15, the orientation of the substrate 11 is set so as to face the vapor deposition source or the sputtering source. That is, the film of the superconductor film constituting the first electrode 13 and the second electrode 15 is formed by a method different from the oblique deposition. As a result, the angle of the flight path of the deposition target particles with respect to the substrate surface can be made substantially uniform over the entire region on the substrate. As a result, it is possible to suppress variations in the area (junction area) of the portion where the three layers of the superconductor film/insulator film/superconductor film overlap in the substrate surface. As a result, the uniformity of the characteristics of the quantum bits including the Josephson junction element 10 in the substrate surface can be improved.

In addition, according to the method for manufacturing a Josephson junction element according to the embodiment of the disclosed technology, the first electrode 13 and the second electrode 15 are formed using resist masks different from each other. That is, the resist mask 40 for forming the second electrode 15 is formed after the formation of the first electrode 13. Therefore, there is a possibility that the surface of the first electrode 13 is contaminated by impurities such as residues of the resist mask 40. Therefore, in the manufacturing method according to the present embodiment, the surface of the first electrode 13 exposed in the opening 45 of the resist mask 40 is etched before the insulator film 14 is formed on the surface of the first electrode 13. As a result, impurities such as residues of the resist mask 40 attached to the surface of the first electrode 13 are removed, and the surface of the first electrode 13 is cleaned. Furthermore, etching of the surface of the first electrode 13, formation of the insulator film 14, and formation of the second electrode 15 and the second wiring 16 are performed by a vacuum-integrated process. This makes it possible to avoid incorporation of impurities into the junction between the first electrode 13 and the insulator film 14 and the junction between the insulator film 14 and the second electrode 15. As described above, according to the method for manufacturing a Josephson junction element according to the embodiment of the disclosed technology, it is possible to suppress variations in the junction area in the substrate surface while avoiding incorporation of impurities into the junction between the superconductor film and the insulator film.

### Second Embodiment

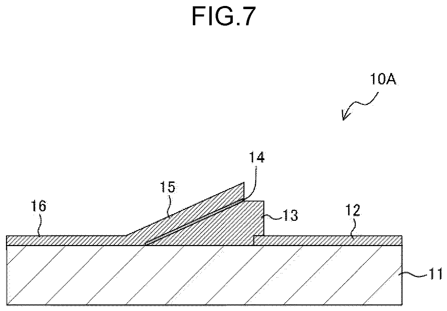

Fig. 7 is a cross-sectional view illustrating an example of a configuration of a Josephson junction element 10A according to a second embodiment of the disclosed technology. In the Josephson junction element 10A, the first electrode 13 continuously changes in thickness from one end to the other end, and has an inclined surface. The first wiring 12 is connected to the end portion of the first electrode 13 having a relatively large thickness. The insulator film 14 and the second electrode 15 are laminated on the inclined surface of the first electrode 13. The second wiring 16 is connected to the second electrode 15 on the side of the end portion where the thickness of the first electrode 13 is relatively small.

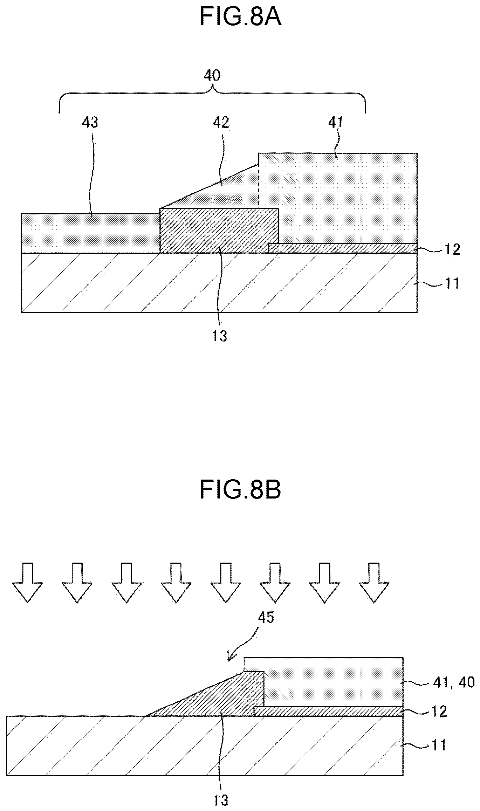

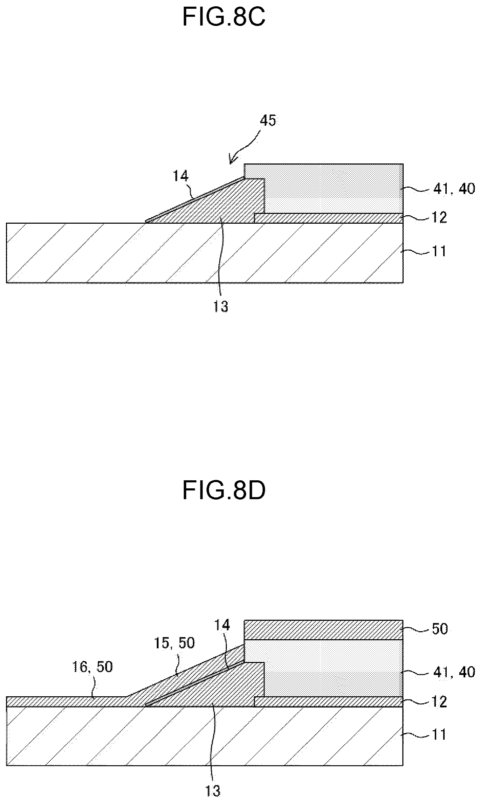

Hereinafter, a method for manufacturing the Josephson junction element 10A will be described. Figs. 8A, 8B, 8C, and 8D are cross-sectional views illustrating an example of a method for manufacturing the Josephson junction element 10A. The step of forming the first wiring 12, the step of forming a resist mask for patterning the first electrode 13, the step of forming a superconductor film constituting the first electrode 13, and the step of patterning the first electrode 13 by removing the resist mask are similar to those of the manufacturing method according to the first embodiment described above, and thus the description thereof will be omitted.

After the patterning of the first electrode 13 is completed, a resist mask 40 for patterning the second electrode 15 and the second wiring 16 by lift-off is formed (Fig. 8A). The resist mask 40 includes a first portion 41 covering the surface of the first wiring 12, a second portion 42 covering the surface of the first electrode 13, and a third portion 43 covering a region corresponding to the second wiring 16 on the surface of the substrate 11. The first portion 41 may include a portion covering an end portion of the first electrode 13 on the first wiring 12 side. The thickness of the second portion 42 continuously changes from one end to the other end, and the surface is inclined. More specifically, the thickness of the second portion 42 continuously increases from the end portion on the second wiring 16 side toward the end portion on the first wiring 12 side. The thickness of the third portion 43 is smaller than the thickness of the first portion 41.

As a technology for forming a plurality of portions having different thicknesses in a resist, gray scale exposure can be used. The gray scale exposure is a technology of directly forming a three-dimensional shape on a resist by exposing the resist using a gray scale mask having density. For example, in a positive-type resist, the thickness of the resist after development becomes relatively small in a region where the intensity of light irradiated at the time of exposure is relatively high.

Next, the surface of the first electrode 13 is etched through the resist mask 40 by dry etching or wet etching (Fig. 8B). The first electrode 13 is sequentially etched from a portion where the thickness of the resist mask 40 covering the surface thereof is relatively thin. Therefore, a three-dimensional shape corresponding to the three-dimensional shape of the second portion 42 of the resist mask 40 is formed on the first electrode 13. That is, in the present etching step, the first electrode 13 is formed into a shape having an inclined surface such that the thickness continuously changes from one end toward the other end. In this etching step, impurities such as residues of the resist mask 40 attached to the surface of the first electrode 13 are removed, and the surface of the first electrode 13 is cleaned. Since the region corresponding to the second wiring 16 on the surface of the substrate 11 is covered with the third portion 43 of the resist mask 40, damage to the region due to etching is suppressed.

At the completion of the etching, the second portion 42 and the third portion 43 are removed from the resist mask 40, and only the first portion 41 remains. That is, the opening 45 corresponding to the pattern of the second electrode 15 and the second wiring 16 is formed in the resist mask 40. The surface of the first electrode 13 is exposed at a portion of the opening 45 corresponding to the second electrode 15, and the surface of the substrate 11 is exposed at a portion of the opening corresponding to the second wiring 16.

Next, the insulator film 14 is formed on the inclined surface of the first electrode 13 exposed at the opening 45 of the resist mask 40 (Fig. 8C). The insulator film 14 is formed by a method similar to the method according to the first embodiment described above.

Next, a superconductor film 50 constituting the second electrode 15 and the second wiring 16 is formed by a vapor deposition method or a sputtering method. The superconductor film 50 is formed on the surface of the insulator film 14 and the substrate 11 exposed at the opening 45 of the resist mask 40, and is formed on the surface of the resist mask 40. The second electrode 15 is formed along the inclined surface of the first electrode 13 (Fig. 8D). The orientation of the substrate 11 during vapor deposition or sputtering is set so as to face the vapor deposition source or the sputtering source.

Next, the excess superconductor film 50 deposited on the resist mask 40 is removed together with the resist mask 40. As a result, the second electrode 15 and the second wiring 16 are patterned, and the Josephson junction element 10A is completed (Fig. 7).

According to the method for manufacturing the Josephson junction element 10A according to the second embodiment of the disclosed technology, similarly to the manufacturing method according to the first embodiment, it is possible to suppress variations in the junction area in the substrate surface while avoiding incorporation of impurities into the junction between the superconductor film and the insulator film.

In addition, in the Josephson junction element 10A according to the second embodiment of the disclosed technology, the first electrode 13 has a structure in which the thickness continuously changes from one end to the other end and the surface is inclined. When the thickness of the first electrode 13 is constant, a step is formed at the end portion of the first electrode 13, and the superconductor film constituting the second electrode 15 and the second wiring 16 covers the step portion. Since the superconductor film is less likely to be deposited in the step portion, the thickness of the superconductor film becomes insufficient in the step portion, and the risk of occurrence of disconnection in the second wiring 16 increases. Furthermore, it may be difficult to remove impurities such as residues of the resist mask in the step portion.

Since the first electrode 13 has the inclined structure, the step formed at the end portion of the first electrode 13 is alleviated. As a result, a portion having an insufficient thickness is less likely to occur in the superconductor film 50 constituting the second electrode 15 and the second wiring 16, and the risk of occurrence of disconnection in the second wiring 16 can be suppressed. In addition, since the step is alleviated, it is easy to remove impurities.

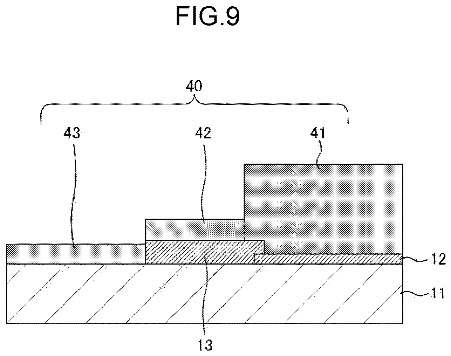

Note that, for example, in a case where the step formed at the end portion of the first electrode 13 does not cause a problem, such as a case where the thickness of the first electrode 13 is thin, the thickness of the second portion 42 of the resist mask 40 may be constant as illustrated in Fig. 9. In the example illustrated in Fig. 9, in the resist mask 40, the thicknesses of the second portion 42 and the third portion 43 are smaller than the thickness of the first portion 41. In this case, the shape of the first electrode 13 after etching is a flat shape having no inclined surface. The resist mask 40 having a plurality of portions having different thicknesses can be formed by gray scale exposure.

In the Josephson junction element, it is possible to suppress variations in the junction area in the substrate surface while avoiding incorporation of impurities into the junction between the superconductor film and the insulator film.

With regard to the first and second embodiments described above, the following supplementary notes are further disclosed.

### (Supplementary note 1)

A method for manufacturing a Josephson junction element, the method including:
forming a first wiring made of a superconductor and a first electrode made of a superconductor connected to the first wiring on a substrate;
forming a resist mask that covers at least the first wiring;
etching a surface of the first electrode using the resist mask;
forming an insulator film on the surface of the first electrode using the resist mask; and
forming a second electrode made of a superconductor on the surface of the insulator film using the resist mask.

### (Supplementary note 2)

The manufacturing method according to Supplementary note 1, in which
the resist mask includes a first portion covering a surface of the first wiring and a second portion covering a surface of the first electrode, and a thickness continuously changes in the second portion.

### (Supplementary note 3)

The manufacturing method according to Supplementary note 1, in which
the resist mask includes a first portion covering a surface of the first wiring and a second portion covering a surface of the first electrode, and
a thickness of the second portion is smaller than a thickness of the first portion.

### (Supplementary note 4)

The manufacturing method according to Supplementary note 2 or 3, in which
the resist mask is formed by gray scale exposure.

### (Supplementary note 5)

The manufacturing method according to Supplementary note 2, in which
an inclination corresponding to a shape of the second portion is formed on the surface of the first electrode by etching the surface of the first electrode through the resist mask.

### (Supplementary note 6)

The manufacturing method according to any one of Supplementary note 1 to 5, in which
the etching of the surface of the first electrode, the formation of the insulator film, and the formation of the second electrode are continuously performed in a common vacuum chamber.

### (Supplementary note 7)

The manufacturing method according to Supplementary note 2 or 3, in which
the resist mask includes a third portion covering a region corresponding to a second wiring made of a superconductor connected to the second electrode on a surface of the substrate,
a thickness of the third portion is smaller than the thickness of the first portion,
the third portion is removed while etching the surface of the first electrode using the resist mask, and
a second electrode is formed on a surface of the insulator film using the resist mask and the second wiring is formed on the surface of the substrate.

### (Supplementary note 8)

A Josephson junction element including:
a first electrode provided on a substrate and having a thickness continuously changing from one end to the other end;
an insulator film provided on a surface of the first electrode;
a second electrode provided on a surface of the insulator film; and
a second wiring provided on the substrate and connected to the second electrode on a side of an end portion having a relatively small thickness of the first electrode.

## Claims

1. A method for manufacturing a Josephson junction element, the method including:
forming a first wiring made of a superconductor and a first electrode made of a superconductor connected to the first wiring on a substrate;
forming a resist mask that covers at least the first wiring;
etching a surface of the first electrode using the resist mask;
forming an insulator film on the surface of the first electrode using the resist mask; and
forming a second electrode made of a superconductor on the surface of the insulator film using the resist mask.

2. The manufacturing method according to claim 1, in which
the resist mask includes a first portion covering a surface of the first wiring and a second portion covering a surface of the first electrode, and a thickness continuously changes in the second portion.

3. The manufacturing method according to claim 1, in which
the resist mask includes a first portion covering a surface of the first wiring and a second portion covering a surface of the first electrode, and
a thickness of the second portion is smaller than a thickness of the first portion.

4. The manufacturing method according to claim 2 or 3, in which
the resist mask is formed by gray scale exposure.

5. The manufacturing method according to claim 2, 3 or 4, in which
an inclination corresponding to a shape of the second portion is formed on the surface of the first electrode by etching the surface of the first electrode through the resist mask.

6. The manufacturing method according to any of claims 2 to 5, in which
the resist mask includes a third portion covering a region corresponding to a second wiring made of a superconductor connected to the second electrode on a surface of the substrate,
a thickness of the third portion is smaller than the thickness of the first portion,
the third portion is removed while etching the surface of the first electrode using the resist mask, and
a second electrode is formed on a surface of the insulator film using the resist mask and the second wiring is formed on the surface of the substrate.

7. The manufacturing method according to any of claims 1 to 6, in which
the etching of the surface of the first electrode, the formation of the insulator film, and the formation of the second electrode are continuously performed in a common vacuum chamber.

8. A Josephson junction element including:
a first electrode provided on a substrate and having a thickness continuously changing from one end to the other end;
an insulator film provided on a surface of the first electrode;
a second electrode provided on a surface of the insulator film; and
a second wiring provided on the substrate and connected to the second electrode on a side of an end portion having a relatively small thickness of the first electrode.
